(19) Europäisches Patentamt

European Patent Office

Office européen des brevets

(11) EP 0 629 876 B1

(12) **EUROPÄISCHE PATENTSCHRIFT**

(45) Veröffentlichungstag und Bekanntmachung des Hinweises auf die Patenterteilung:
**01.09.1999 Patentblatt 1999/35**

(51) Int Cl.⁶: **G01R 33/56**

(21) Anmeldenummer: **94201644.5**

(22) Anmeldetag: **09.06.1994**

(54) **Verfahren zur Erzeugung einer MR-Bildfolge und Anordnung zur Durchführung des Verfahren**

Method for generating an MR imaging sequence and device for carrying out the method

Procédé pour la génération d'une séquence d'image RM et dispositif pour la mise en oeuvre du procédé

(84) Benannte Vertragsstaaten:
**DE FR GB NL**

(30) Priorität: **12.06.1993 DE 4319539**

(43) Veröffentlichungstag der Anmeldung:
**21.12.1994 Patentblatt 1994/51**

(73) Patentinhaber:
- **Philips Patentverwaltung GmbH**
  **22335 Hamburg (DE)**
  Benannte Vertragsstaaten:
  **DE**
- **Koninklijke Philips Electronics N.V.**
  **5621 BA Eindhoven (NL)**
  Benannte Vertragsstaaten:
  **FR GB NL**

(72) Erfinder:
- **Kuhn, Michael Harald, Dr.-Ing.**
  **D-20097 Hamburg (DE)**
- **Rasche, Volker**
  **D-20097 Hamburg (DE)**
- **Proksa, Roland**
  **D-20097 Hamburg (DE)**

(74) Vertreter: **Hartmann, Heinrich, Dipl.-Ing. et al**
**Philips Patentverwaltung GmbH,**
**Röntgenstrasse 24**
**22335 Hamburg (DE)**

(56) Entgegenhaltungen:
**EP-A- 0 073 671**        **EP-A- 0 191 431**
**GB-A- 2 037 996**        **US-A- 4 710 717**
**US-A- 4 727 325**        **US-A- 4 797 616**
**US-A- 4 830 012**

**Beschreibung**

Die Erfindung betrifft ein Verfahren gemäß dem Oberbegriff des Anspruchs 1. Ein solches Verfahren und eine zu seiner Durchführung geeignete Anordnung sind aus der US-PS 4,830,012 bekannt. Mit diesem Verfahren ist es möglich, eine schnelle Bildfolge mit vergleichsweise hoher räumlicher Auflösung zu erzeugen, wobei der zeitliche Abstand zwischen zwei MR-Bildern wesentlich kleiner sein kann als der für die Erzeugung eines einzigen MR-Bildes mit dieser räumlichen Auflösung erforderliche Zeitraum.

Bei dem bekannten Verfahren werden zunächst N Sequenzen erzeugt (wobei N zwischen 16 und 128 liegen kann), wobei die Größe eines zwischen dem Hochfrequenzimpuls und dem Auslesen des dadurch erzeugten MR-Signales wirksamen Phasencodierungsgradienten von Sequenz zu Sequenz geändert wird. Der Phasencodierungsgradient verläuft in einer ersten Richtung, die senkrecht zu einer zweiten Richtung verläuft, die der während des Auslesens wirksame Gradient hat. Danach wird diese Folge von Sequenzen ein- oder mehrmals wiederholt. Aus den ersten N Sequenzen wird ein erstes MR-Bild rekonstruiert. Danach erfolgt eine Aktualisierung (update) des MR-Bildes mit Hilfe der nächsten n MR-Signale, wobei n klein ist im Vergleich zu N, z.B. 2 oder 4. Dabei werden die ersten n MR-Signale (bzw. deren Fouriertransformierte) durch die n zuletzt erzeugten MR-Signale ersetzt, so daß im Endeffekt das neue MR-Bild aus N-n Sequenzen, die schon zur Rekonstruktion des vorangegangenen MR-Bildes herangezogen wurden, und n neuen MR-Sequenzen rekonstruiert wird. Der zeitliche Abstand zwischen zwei MR-Bildern kann dabei im Verhältnis n/N kleiner sein als die Dauer des Zeitraums zur Erfassung der N für ein Bild erforderlichen MR-Signale.

Dynamische Vorgänge im Untersuchungsbereich können zu Artefakten in den auf diese Weise erzeugten MR-Bildern führen, und zwar auch dann, wenn die Phasencodierungsgradienten für niedrige Ortsfrequenzen häufiger erzeugt werden als andere (US-PS 4,830,012, Spalte 5, Zeilen 19 ff).

Aufgabe der vorliegenden Erfindung ist es, ein Verfahren der eingangs genannten Art so auszugestalten, daß bei dynamischen Vorgängen im Untersuchungsbereich weniger Artefakte auftreten. Diese Aufgabe wird erfindungsgemäß durch die in Anspruch 1 angegebenen Maßnahmen gelöst. Eine geeignete Anordnung zur Durchführung dieses Verfahrens ist in Anspruch 2 angegeben. Mit der Ausgestaltung nach Anspruch 4 lassen sich durch den Herzschlag verursachte Unschärfen weitgehend vermeiden.

Das Erfassen der MR-Signale in Verbindung mit einem von Sequenz zu Sequenz in seiner Richtung geänderten magnetischen Gradientenfeld entspricht der bekannten Projektions-Rekonstruktionsmethode (im Gegensatz zu dem 2DF-Verfahren bei der US-PS 4,830,012). Von dieser Methode ist aus der EP-A 73 671 bekannt, daß man mit wenigen, gleichmäßig über den sogenannten k-Raum verteilten Sequenzen schon MR-Bilder mit geringer räumlicher Auflösung erzeugen kann; dies wird bei dem bekannten Verfahren dazu ausgenutzt, um zunächst ein grobes Bild und danach gegebenenfalls ein höher aufgelöstes MR-Bild zu erzeugen.

Bei der Erfindung verteilen sich die Gradientenrichtungen bei den für das jeweils nächste Bild neu hinzukommenden n MR-Signalen gleichmäßig über den k-Raum, so daß großflächige Änderungen im Untersuchungsbereich in der Bildfolge artefaktarm wiedergegeben werden können.

Die Erfindung wird nachstehend anhand der Zeichnungen erläutert. Es zeigen:

Fig. 1 ein Gerät zur Durchführung des erfindungsgemäßen Verfahrens,

Fig. 2 den zeitlichen Verlauf der dabei benutzten Sequenz,

Fig. 3 die bei einer Sequenz gewonnenen MR-Daten in bezug auf den Unter suchungsbereich,

Fig. 4 die zeitliche Folge der Sequenzen,

Fig. 5 die Abtastung des k-Raums durch die verschiedenen Sequenzen,

Fig. 6 ein Blockschaltbild einer die MR-Signale verarbeitenden Einheit.

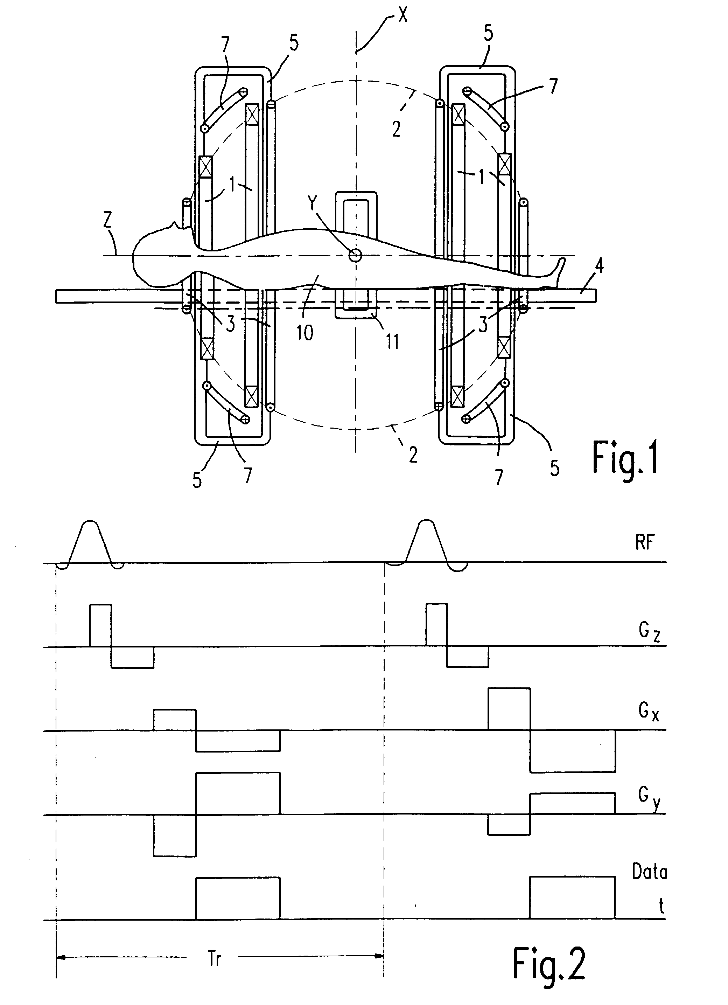

Das in Fig. 1 dargestellte Gerät ist ein MR-Gerät mit einer aus vier Spulen 1 bestehenden Anordnung zur Erzeugung eines homogenen stationären Magnetfeldes, das in der Größenordnung von einigen Zehntel Tesla bis einigen Tesla liegen kann. Die zur z-Achse konzentrisch angeordneten Spulen 1 können auf einer Kugelfläche 2 angeordnet sein. Im Innern dieser Spule befindet sich der zu untersuchende Patient 10 auf einer Tischplatte 4.

Zur Erzeugung eines in z-Richtung verlaufenden und sich in dieser Richtung linear ändernden Magnetfeldes (das im folgenden auch als magnetisches Gradientenfeld bezeichnet wird) sind vier Spulen 3 auf der Kugeloberfläche 2 angeordnet. Weiterhin sind vier Spulen 7 vorgesehen, die ein ebenfalls in z-Richtung verlaufendes magnetisches Gradientenfeld erzeugen, dessen Gradient jedoch in x-Richtung (vertikal) verläuft. Ein in z-Richtung verlaufendes magnetisches Gradientenfeld mit einem Gradienten in y-Richtung (senkrecht zur Zeichenebene der Fig. 1) wird von vier Spulen 5 erzeugt, die mit den Spulen 7 identisch sein können, die jedoch diesen gegenüber um 90° räumlich versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder symmetrisch zur Kugeloberfläche angeordnet ist, ist die Feldstärke im Kugelzentrum nur durch das stationäre homogene Magnetfeld der Spule 1 bestimmt.

Weiterhin ist eine Hochfrequenzspule 11 vorgesehen, die ein im wesentlichen homogenes und senkrecht zur Richtung des stationären homogenen Magnetfeldes (d.h. senkrecht zur z-Richtung) verlaufendes hochfrequentes Magnetfeld erzeugt. Der Hochfrequenzspule wird während jedes Hochfrequenzimpulses ein hochfrequenter modulierter Strom von einem Hochfrequenzgenerator zugeführt. Die Hochfrequenzspule 11 kann ebenfalls zum Empfangen der im Untersuchungsbereich erzeugten Kernresonanzsignale eingesetzt werden. Es ist jedoch auch möglich, dafür eine gesonderte, in Fig. 1 nicht näher dargestellte Hochfrequenzempfangsspule zu verwenden.

Fig. 2 zeigt die zeitliche Lage verschiedener Signale bei zwei aufeinanderfolgenden Sequenzen, die bei der Durchführung des erfindungsgemäßen Verfahrens benutzt werden. In der ersten Zeile ist ein Hochfrequenzimpuls dargestellt, der in Verbindung mit einem magnetischen Gradientenfeld $G_z$ (zweite Zeile) als schichtselektiver Hochfrequenzimpuls wirksam ist. Durch diesen Hochfrequenzimpuls wird die Kernmagnetisierung in einer zur z-Achse senkrechten Schicht um einen geringen Flipwinkel (z.B. 5°) aus ihrer Ruhelage gekippt. Danach wirken zwei magnetische Gradientenfelder $G_x$ und $G_y$ (dritte und vierte Zeile) gleichzeitig auf den Untersuchungsbereich ein, wobei beide Felder zu einem bestimmten Zeitpunkt die Richtung ihres Gradienten umkehren. Der zeitliche Verlauf ist dabei so gewählt, daß das zeitliche Integral über den Gradienten bis zur Polaritätsumkehr halb so groß ist, wie das zeitliche Integral von der Polaritätsumkehr bis zum Abschalten des magnetischen Gradientenfeldes. Grundsätzlich kann aber auch der vor der Polaritätsumkehr befindliche Teil des magnetischen Gradientenfeldes entfallen.

Während die magnetischen Gradientenfelder $G_x$ und $G_y$ konstant sind, werden die im Untersuchungsbereich erzeugten MR-Signale verstärkt, in das Basisband transponiert und digitalisiert (fünfte Zeile von Fig. 2). Die Zahl der Abtastwerte, die dabei gewonnen werden, hängt vom gewünschten Auflösungsvermögen ab sowie von der Größe des Untersuchungsbereichs. Die digitalisierten MR-Signale werden einer eindimensionalen Fouriertransformation unterzogen, wonach soviel transformierte Werte zur Verfügung stehen, wie vorher Abtastwerte vorhanden waren.

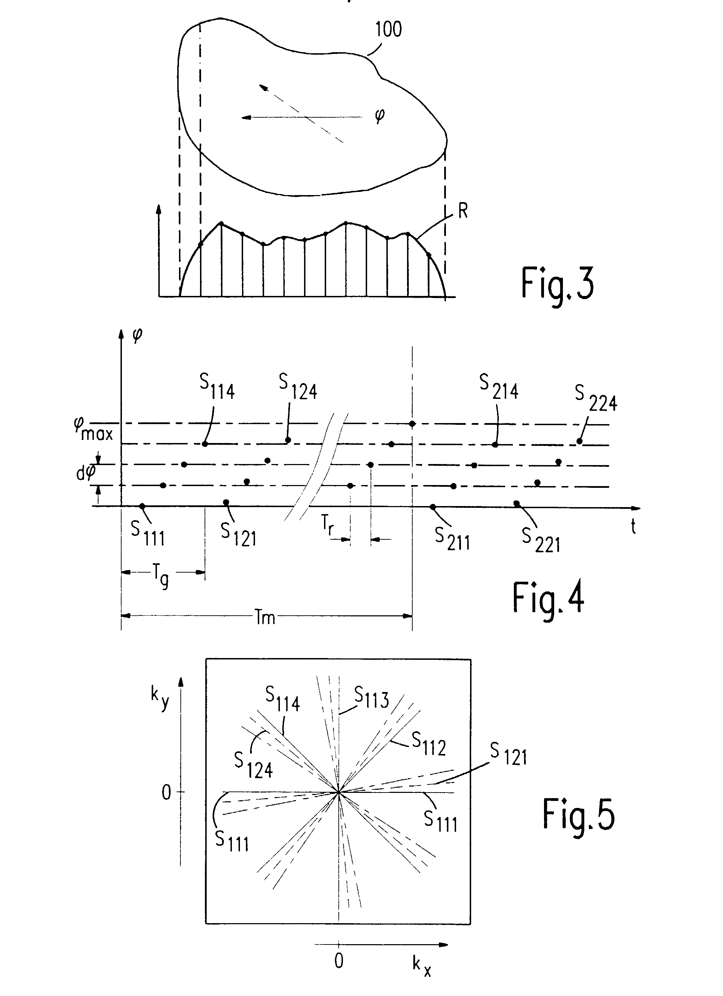

In Fig. 3 ist die durch die Sequenz angeregte Schicht mit 100 bezeichnet und die Richtung, die das magnetische Gradientenfeld in dieser Schicht bei der Sequenz hat, mit $\varphi$. Unterhalb des Untersuchungsbereichs ist eine Kurve R eingezeichnet, die das Frequenzspektrum des bei einer Sequenz aufgenommenen MR-Signals darstellt. Dieses Frequenzspektrum ergibt sich durch die eindimensionale Fouriertransformation des MR-Signals. Da sich die Frequenz der Kernspins in Richtung $\varphi$ linear mit dem Ort ändert, stellt das Frequenzspektrum R die Projektion der Kernmagnetisierung auf eine in Richtung $\varphi$ verlaufende Gerade dar. Jeder Amplitudenwert des Spektrums entspricht dem Linienintegral der Kernmagnetisierungsdichte über einen zur Richtung $\varphi$ senkrechten Pfad innerhalb der Schicht für einen bestimmten Ort. Somit ergibt sich diese Projektion für jeden Ort aus der Kurve R, wie durch gestrichelte Linien angedeutet.

Nach einer Repetitionszeit $T_r$ von z.B. 10 ms wird die Sequenz wiederholt, wobei die Größe der gleichzeitig eingeschalteten Gradienten Gx und Gy gegensinnig zueinander geändert wird, so daß die Summe der Quadrate dieser Gradienten konstant bleibt. Das hat zur Folge, daß das aus der Überlagerung der magnetischen Gradientenfelder Gx und Gy resultierende magnetische Gradientenfeld seine Richtung $\varphi$ in der z-Ebene ändert, wobei der Betrag seines Gradienten konstant bleibt. Es folgen weitere Sequenzen mit von Sequenz zu Sequenz geänderter Richtung $\varphi$ des Gradienten bis nach N Sequenzen (N kann zwischen 32 und 256 liegen) mit gleichmäßig verteilten Gradientenrichtungen ein Satz von MR-Daten zur Verfügung steht, mit dem ein MR-Bild der durch die Hochfrequenzimpulse angeregten Schicht rekonstruiert werden kann. Danach wird das Ganze einmal oder mehrere Male wiederholt.

Im folgenden wird in Verbindung mit Fig. 4 erläutert, wie aus den bei den Sequenzen gewonnenen MR-Signalen eine Folge von MR-Bildern abgeleitet werden kann. Diese Folge soll die dynamischen Vorgänge im Untersuchungsbereich mit einer Frequenz f wiedergeben. Wenn die Frequenz f, mit der die MR-Bilder aufeinander folgen, beispielsweise 25 Bilder/Sekunde betragen soll, dann stehen pro Bild 40 ms zur Verfügung. Innerhalb dieses Zeitraums können (bei der angegebenen Repetitionszeit $T_r$) n=4 Sequenzen erzeugt werden.

Fig. 4 zeigt die zeitlichen Abläufe bei der Erfassung der MR-Daten, wobei als Ordinate die Gradientenrichtung und als Abszisse die Zeit aufgetragen ist. Jeder Punkt in diesem Diagramm entspricht der Erfassung eines MR-Signales, so daß der zeitliche Abstand zwischen zwei aufeinanderfolgenden Punkten (MR-Signalen) der Repetitionszeit $T_r$ der in Fig. 2 dargestellten Sequenz entspricht. Der Winkelbereich zwischen 0 und $\varphi_{max}$ ist dabei der Bereich der Gradientenrichtungen, der für eine vollständige Rekonstruktion der Kernmagnetisierungsverteilung im Untersuchungsbereich erforderlich ist. Bei der in Fig. 2 dargestellten Sequenz beträgt $\varphi_{max}$ 180°; wenn der vor dem Auslesen der MR-Signale (5. Zeile) wirksame Teil der Gradienten Gx und Gy weggelassen wird, ergibt der FID (free induction decay - freier Induktionszerfall) ein asymmetrisches Gradientenecho; in diesem Fall beträgt $\varphi_{max}$ 360°.

Die Sequenzen sind in Gruppen zu je n Sequenzen (n=4) zusammengefaßt. Die mit diesen Sequenzen verknüpften Gradientenrichtungen unterscheiden sich innerhalb der Gruppe jeweils um d$\varphi$, wobei die Beziehung gilt:

$$d\varphi = \varphi_{max}/n \qquad (1)$$

Die zur Akquisition der MR-Signale einer Gruppe benötigte Zeit ist in Fig. 4 mit $T_g$ bezeichnet, wobei die Beziehung gilt:

$$T_g = nT_r = 1/f \qquad (2)$$

Zum Erfassen der für die Rekonstruktion eines MR-Bildes erforderlichen N MR-Signale sind demnach N/n Gruppen solcher Sequenzen erforderlich. Die dafür benötigte Meßzeit $T_m$ beträgt $N \cdot T_r$, bei $N = 128$ und $T_r = 10$ ms also rund 1,3 sek.

Fig. 5 veranschaulicht die Sequenzen im k-Raum. Die Koordinaten $k_x$, $k_y$ des k-Raums stellen das zeitliche Integral über das Gradientenfeld Gx bzw. Gy während des Auslesens der MR-Signale dar. Jede Sequenz bzw. jedes davon erzeugte MR-Signal entspricht einer Geraden durch den Nullpunkt des k-Raums, wobei die Richtung der Geraden der Gradientenrichtung entspricht. Die vier Sequenzen der ersten Gruppe bzw. die damit verbundenen MR-Signale sind in Fig. 4 bzw. Fig. 5 mit $S_{111}$, $S_{112}$, $S_{113}$ und $S_{114}$ bezeichnet. Diese Sequenzen sind in Fig. 5 mit ausgezogenen Linien dargestellt.

Die Gradientenrichtungen der in Fig. 4 bzw. Fig. 5 mit $S_{121} \ldots S_{124}$ bezeichneten zweiten Gruppe sind in Fig. 5 durch eine gestrichelte Gerade angedeutet und die Gradientenrichtungen einer weiteren Gruppe durch strichpunktierte Geraden. Man erkennt, daß die Gradientenrichtungen einer Gruppe sich von denen jeder anderen Gruppe jeweils um einen konstanten Winkel unterscheiden, und zwar so, daß die Richtungen der N Sequenzen der N/n Sequenzengruppen sich gleichmäßig über den k-Raum verteilen.

Nachdem auf diese Weise N Sequenzen in der Meßzeit $T_m$ erzeugt worden sind, werden diese Sequenzen - ohne irgendwelche Änderungen - noch ein oder mehrere Male wiederholt. Die Sequenzen der ersten Gruppe dieser Wiederholung sind in Fig. 4 mit $S_{211} \ldots S_{214}$ bezeichnet; sie sind mit den Sequenzen $S_{111} \ldots S_{114}$ identisch. Ebenso sind die Sequenzen $S_{221} \ldots S_{224}$ der zweiten Gruppe dieser Wiederholung identisch mit den Sequenzen $S_{121} \ldots S_{124}$ usw.

Aus den ersten N Sequenzen kann ein erstes MR-Bild rekonstruiert werden. Bis zur Rekonstruktion dieses ersten Bildes verstreicht der Zeitraum $T_m$.

Das zweite MR-Bild wird im wesentlichen mit den gleichen MR-Daten rekonstruiert wie das erste, wobei lediglich die von der ersten Gruppe von Sequenzen $S_{111} \ldots S_{114}$ gelieferten MR-Daten durch die MR-Daten der Gruppe $S_{211} \ldots S_{214}$ ersetzt werden. Die letztgenannten MR-Daten stehen entsprechend dem Zeitraum $T_g$ (40 ms) nach der Akquisition des MR-Datensatzes für das erste Bild zur Verfügung. Bei dem dritten Bild der Bildfolge, für das die Datenakquisition nach weiteren 40 ms abgeschlossen ist, werden zusätzlich die von der zweiten Gruppe $S_{121} \ldots S_{124}$ gelieferten MR-Daten durch die von der zweiten Gruppe $S_{221} \ldots S_{224}$ der Sequenzen der Wiederholung gelieferten MR-Daten ersetzt. Auf diese Weise kann jeweils nach dem Zeitraum $T_g$ ein durch eine weitere Gruppe von Sequenzen aktualisiertes MR-Bild erzeugt werden. Da in jeder Gruppe von Sequenzen die Gradientenrichtung gleichmäßig über den k-Raum verteilt sind (vergl. Fig. 5), ist in den von einer solchen Gruppe gelieferten MR-Daten die Information für ein vollständiges MR-Bild mit richtungsunabhängiger, geringer räumlicher Auflösung enthalten. Dadurch werden die geschilderten Artefakte des bekannten Verfahrens weitestgehend vermieden.

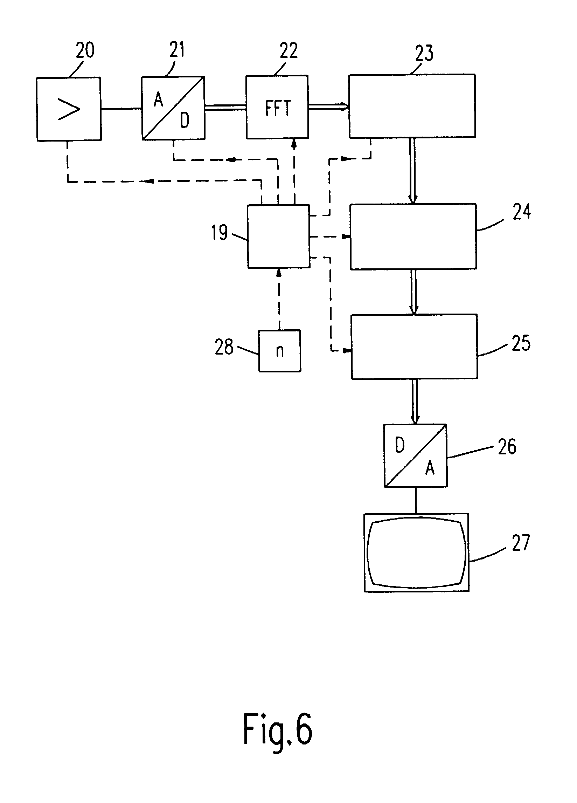

Fig. 6 zeigt das Blockschaltbild einer Signalverarbeitungseinheit, mit der aus den MR-Signalen eine Folge von MR-Bildern rekonstruiert werden kann. Die bei den einzelnen Sequenzen empfangenen MR-Signale werden von einer Einheit 20 verstärkt und in das Basisband transponiert. Das so erhaltene analoge Signal wird von einem Analog-Digital-Wandler 21 in eine Folge von Digitalwerten umgesetzt. Der Analog-Digital-Wandler 21 wird von einer Steuereinheit 19 so gesteuert, daß er nur während der Auslesephase (vergl. 5. Zeile von Fig. 2) digitale Datenworte erzeugt. Dem Analog-Digital-Wandler 21 ist eine Einheit 22 zur schnellen Fouriertransformation nachgeschaltet, die eine eindimensionale Fouriertransformation über die durch die Digitalisierung eines MR-Signals entstehende Folge von Abtastwerten durchführt, vorzugsweise so schnell, daß die Fouriertransformation beendet ist, bevor das nächste MR-Signal empfangen wird.

Die auf diese Weise digitalisierten und fouriertransformierten MR-Signale werden in einen Speicher 23 geschrieben. Aus diesen Daten im Speicher 23 wird mit einer Verarbeitungseinheit 24 eine gefilterte Rückprojektion durchgeführt, woraus sich die Stärke der Kernmagnetisierung in den einzelnen Bildelementen eines MR-Bildes ergibt, das in dem Speicher 25 gespeichert wird. Über einen Digital-Analog-Wandler 26 wird dieses Bild auf einem Monitor 27 wiedergegeben.

Die Einheiten 23 . . . 27 werden von einer Steuereinheit 19 so gesteuert, daß nach den ersten N Sequenzen ein erstes MR-Bild im Speicher 25 erzeugt und auf dem Monitor 27 wiedergegeben wird. Nach n weiteren Sequenzen wird dieses MR-Bild mit Hilfe dieser Sequenzen aktualisiert. Zu diesem Zweck wäre es denkbar, die Fouriertransformierten der Signale $S_{111} \ldots S_{114}$ durch die Fouriertransformierten der Signale $S_{211} \ldots S_{214}$ zu ersetzen und mit diesen neu hinzugekommenen Daten sowie mit den Fouriertransformierten der N-n vorangehenden MR-Signale eine erneute gefilterte Rückprojektion durchzuführen. Bei dieser erneuten Rückprojektion wären aber wiederum N Fouriertransformierte zu verarbeiten.

Wesentlich einfacher ist es, analog zu dem Vorgehen in der US-PS 4,830,012 nur jeweils die Differenz zwischen den n neu hinzugekommenen Fouriertransformierten und den n durch sie ersetzten Fouriertransformierten zu bilden (also $S_{211} - S_{111} \ldots S_{214} - S_{114}$)

und die Einheit 24 lediglich den Beitrag dieser n Differenzen zu den einzelnen Bildpunkten des MR-Bildes berechnen und dem gespeicherten Bild überlagern zu lassen.

Wie schon erwähnt, liefert jede der für ein neues MR-Bild herangezogenen Gruppen von Sequenzen für sich allein bereits die Information für ein MR-Bild mit geringer Auflösung. Die Auflösung kann vergrößert werden, indem z.B. $n = 8$ (anstatt $n = 4$) Sequenzen jeweils zu einer Gruppe zusammengefaßt werden, wobei die n Gradientenrichtungen jeder Gruppe wiederum gleichmäßig auf den k-Raum verteilt werden müssen. Allerdings ist bei dieser dann verdoppelten räumlichen Auflösung die Bildfolgefrequenz $(f = 1/(nT_r))$ nur noch halb so groß. - Je nach dem Untersuchungsverfahren kann man aber auch den Wert n erniedrigen und somit die Bildfolgefrequenz f erhöhen und die räumliche Auflösung verringern. Um diese Untersuchungsparameter den jeweiligen Bedürfnissen anpassen zu können, ist eine Eingabeeinheit 28 vorgesehen, z.B. eine Tastatur, über die der Benutzer den Wert n und damit die Bildfolgefrequenz sowie die räumliche Auflösung einstellen kann.

## Patentansprüche

1. Verfahren zur Erzeugung einer Folge von MR-Bildern, bei dem in Anwesenheit eines stationären Magnetfeldes fortlaufend Sequenzen mit wenigstens einem Hochfrequenzimpuls und einem von Sequenz zu Sequenz veränderten magnetischen Gradientenfeld auf den Untersuchungsbereich einwirken und aus den dabei erzeugten MR-Signalen MR-Bilder rekonstruiert werden, wobei die ältesten zur Rekonstruktion eines MR-Bildes herangezogenen MR-Signale ($S_{111}$ ... $S_{114}$) bei der Rekonstruktion des nachfolgenden MR-Bildes durch die jeweils neu erzeugten MR-Signale ($S_{211}$ ... $S_{214}$) ersetzt werden, deren Anzahl (n) klein ist im Vergleich zu der zur Rekonstruktion eines vollständigen Bildes erforderlichen Zahl (N) von MR-Signalen, dadurch gekennzeichnet, daß die Richtung (4) des während der Erzeugung eines MR-Signales wirksamen magnetischen Gradientenfeldes ($G_x$, $G_y$) von Sequenz zu Sequenz so geändert wird, daß sich die Richtungen des Gradientenfeldes für die jeweils neu erzeugten MR-Signale gleichmäßig auf den Bereich (0 ... $\varphi_{max}$) der für die Rekonstruktion erforderlichen Richtungen des magnetischen Gradientenfeldes verteilen.

2. Anordnung zur Durchführung des Verfahrens nach Anspruch 1, mit

a) einem Magneten (1) zur Erzeugung eines homogenen stationären Magnetfeldes,
b) einer Hochfrequenzspulenanordnung (11) zur Erzeugung von Hochfrequenzimpulsen,
c) einer Gradientenspulenanordnung (3,5,7) zur Erzeugung von magnetischen Gradientenfeldern mit veränderbarer Gradientenrichtung,
d) Mitteln zur Erzeugung von MR-Sequenzen mit wenigstens einem Hochfrequenzimpuls und von Sequenz zu Sequenz veränderter Richtung des beim Empfang der MR-Signale wirksamen Gradientenfeldes,
e) Mitteln (20,21) zur Erfassung der durch die Sequenzen erzeugten MR-Signale,
f) Mitteln (22-25) zur Rekonstruktion von MR-Bildern aus den MR-Signalen, sowie
g) einer Steuerungseinheit (19), die die genannten Mittel so steuert, daß nach dem Empfang einer Anzahl von MR-Signalen, deren Anzahl (n) klein ist im Vergleich zu der zur Rekonstruktion eines vollständigen Bildes erforderlichen Zahl (N) von MR-Signalen, ein aktualisiertes MR-Bild rekonstruiert wird, wobei die ältesten zur Rekonstruktion eines MR-Bildes herangezogenen MR-Signale ($S_{111}$ ... $S_{114}$) bei der Rekonstruktion des nachfolgenden MR-Bildes durch die jeweils neu erzeugten MR-Signale ($S_{211}$ ... $S_{214}$) ersetzt werden, und daß die Richtung (4) des während der Erzeugung eines MR-Signales wirksamen magnetischen Gradientenfeldes ($G_x$, $G_y$) von Sequenz zu Sequenz so geändert wird, daß sich die Richtungen des Gradientenfeldes für die jeweils neu erzeugten MR-Signale gleichmäßig auf den Bereich (0 ... $\varphi_{max}$) der für die Rekonstruktion erforderlichen Richtungen des magnetischen Gradientenfeldes verteilen.

3. Anordnung nach Anspruch 2, gekennzeichnet durch Mittel (28) zum Eingeben der Zahl(n) der aktualisierten MR-Signale, die jeweils zum Erzeugen eines aktualisierten MR-Bildes herangezogen werden.

4. Anordnung nach Anspruch 2 oder 3, gekennzeichnet durch Mittel zum Synchronisieren der Sequenzen mit dem EKG eines im Untersuchungsbereich befindlichen Patienten.

## Claims

1. A method of forming a series of MR images, in which sequences with at least one RF pulse and a magnetic gradient field which varies from one sequence to another act continuously on the examination zone in the presence of a steady magnetic field, MR images being reconstructed from the MR signals thus generated, the oldest MR signals ($S_{111}$ ... $S_{114}$) used for the reconstruction of an MR image being replaced by the respective newly generated MR sig-

nals ($S_{211}$ ... $S_{214}$) for the reconstruction of the next MR image, their number (n) being small in comparison with the number (N) of MR signals required for the reconstruction of a complete image, <u>characterized in that</u> the direction (4) of the magnetic gradient field ($G_x$, $G_y$) active during the formation of an MR signal is varied from one sequence to another so that the directions of the gradient field for the respective newly generated MR signals are uniformly distributed across the range (0...$\varphi_{max}$) of the directions of the magnetic gradient field required for the reconstruction.

2. A device for carrying out the method claimed in Claim 1, including

    a) a magnet (1) for generating a uniform, steady magnetic field,
    b) an RF coil system (11) for generating RF pulses,
    c) a gradient coil system (3, 5, 7) for generating magnetic gradient fields with a variable gradient direction,
    d) means for generating MR sequences with at least one RF pulse and a direction of the gradient field, active upon reception of the MR signals, which is varied from one sequence to another,
    e) means (20, 21) for acquiring the MR signals generated by the sequences,
    f) means (22-25) for the reconstruction of MR images from the MR signals, as well as
    g) control unit (19) which controls said means in such a manner that, after the reception of a number of MR signals whose number (n) is small in comparison with the number (N) of MR signals required for the reconstruction of a complete image, an updated MR image is reconstructed, the oldest MR signals ($S_{111}$...$S_{114}$) used for the reconstruction of an MR image being replaced by the respective newly generated MR signals ($S_{211}$ ...$S_{214}$) for the reconstruction of the next MR image, the direction (4) of the magnetic gradient field ($G_x$, $G_y$) active during the formation of an MR signal being varied from one sequence to another so that the directions of the gradient field for the respective newly generated MR signals are uniformly distributed across the range (0...$\varphi_{max}$) of the directions of the magnetic gradient field required for the reconstruction.

3. A device as claimed in Claim 2, <u>characterized in that</u> it comprises means (28) for entering the number (n) of updated MR signals each time used to generate an updated MR image.

4. A device as claimed in Claim 2 or 3, <u>characterized in that</u> it comprises means for synchronizing the sequences with the ECG of a patient arranged in the examination zone.

## Revendications

1. Procédé de production d'une séquence d'images RM, des séquences avec au moins une impulsion à haute fréquence et un champ à gradient magnétique évoluant d'une séquence à l'autre agissant en permanence sur la zone d'examen en présence d'un champ magnétique stationnaire et, à partir des signaux RM produits à cette occasion, des images RM étant reconstruites, les plus anciens des signaux RM ($S_{111}$...$S_{114}$) utilisés pour la reconstruction d'une image RM étant remplacés lors de la reconstruction de l'image RM suivante par les derniers signaux RM produits ($S_{211}$...$S_{214}$) dont le nombre (n) est minime par rapport au nombre (N) de signaux RM nécessaires pour la reconstruction d'une image complète, <u>caractérisé en ce</u> que la direction (4) du champ à gradient ($G_x$, $G_y$) magnétique actif pendant la production d'un signal RM varie d'une séquence à l'autre de telle sorte que les directions du champ à gradient pour les derniers signaux RM produits se répartissent uniformément sur la zone (0...$\varphi_{max}$) des directions du champ à gradient magnétique nécessaires pour la reconstruction.

2. Dispositif de mise en oeuvre du procédé selon la revendication 1, avec

    a) un aimant (1) en vue de la production d'un champ magnétique stationnaire homogène;
    b) un agencement de bobines à haute fréquence (11) en vue de la production d'impulsions à haute fréquence;
    c) un agencement de bobines à gradient (3, 5, 7) en vue de la production de champs à gradient magnétiques avec une direction de gradient variable;
    d) des moyens en vue de la production de séquences RM avec au moins une impulsion à haute fréquence et une direction du champ à gradient actif lors de la réception des signaux RM évoluant d'une séquence à l'autre,
    e) des moyens (20, 21) en vue de l'enregistrement des signaux RM produits par les séquences,
    f) des moyens (22, 25) en vue de la reconstruction d'images RM à partir de signaux RM ainsi que
    g) une unité de commande (19) qui commande les moyens précités de telle sorte qu'après la réception d'un nombre de signaux RM dont le nombre (n) est minime par rapport au nombre (N) de signaux RM nécessaires pour la reconstruction d'une image complète, une image RM actualisée est reconstruite, les plus anciens des signaux RM utilisés pour la reconstruction d'une image RM ($S_{111}...S_{114}$) étant remplacés lors de la reconstruction de l'image RM suivante par les nouveaux signaux RM respectivement produits ($S_{211}...S_{214}$) et en ce que la direction (4) et du champ à gradient magnétique ($G_x$, $G_y$) actif pendant la production d'un signal RM varie d'une séquence à l'autre de telle sorte que les directions du champ à gradient pour les signaux RM produits respectivement se répartissent uniformément sur la zone ($0...\varphi_{max}$) des directions du champ à gradient magnétique nécessaires pour la reconstruction.

3.  Dispositif selon la revendication 2,
    <u>caractérisé par</u> des moyens (28) en vue de l'introduction du nombre (n) des signaux RM actualisés qui sont respectivement utilisés pour la production d'une image RM actualisée.

4.  Dispositif selon l'une des revendications 2 ou 3,
    <u>caractérisé par</u> des moyens de synchronisation des séquences avec l'ECG d'un patient se trouvant dans la zone d'examen

Fig.1

Fig.2

Fig.3

Fig.4

Fig.5

9

Fig.6